(19) Europäisches Patentamt
European Patent Office
Office européen des brevets

(11) Veröffentlichungsnummer: **0 239 866 B1**

(12) **EUROPÄISCHE PATENTSCHRIFT**

(45) Veröffentlichungstag der Patentschrift: **27.11.91**

(51) Int. Cl.5: **H01L 29/74**, H01L 29/72, H01L 29/08, H01L 29/10

(21) Anmeldenummer: **87103876.6**

(22) Anmeldetag: **17.03.87**

(54) **Abschaltbares Halbleiterbauelement sowie Verwendung desselben.**

(30) Priorität: **20.03.86 CH 1114/86**

(43) Veröffentlichungstag der Anmeldung:
**07.10.87 Patentblatt 87/41**

(45) Bekanntmachung des Hinweises auf die Patenterteilung:
**27.11.91 Patentblatt 91/48**

(84) Benannte Vertragsstaaten:
**CH DE FR GB IT LI NL SE**

(56) Entgegenhaltungen:
EP-A- 0 028 797      EP-A- 0 121 068
EP-A- 0 158 186      EP-A- 0 164 292
EP-A- 0 194 199      EP-A- 0 194 946
US-A- 4 086 611

PATENT ABSTRACTS OF JAPAN, Band 9, Nr. 85 (E-308)[1808], 13. April 1985; & JP-A-59 217 365

PATENT ABSTRACTS OF JAPAN, Band 10, Nr. 113 (E-399)[2170], 26. April 1986; & JP-A-60 247 969

PATENT ABSTRACTS OF JAPAN, Band 6, Nr. 164 (E-127)[1042], 27. August 1982; & JP-A-57 83 057

Solid State Electronics, vol. 25, No. 5, pp.345-353 (1982); B.J. Baliga: "High Gain Power Switching Using Field Controlled Thyristors"

(73) Patentinhaber: **BBC Aktiengesellschaft Brown, Boveri & Cie.**
**Haselstrasse**
**CH-5401 Baden(CH)**

(72) Erfinder: **Abbas, Christiaan C., Dr.**
**Im Eichtal 2**
**CH-5400 Baden(CH)**

## Beschreibung

Die vorliegende Erfindung betrifft ein abschaltbares Halbleiterbauelement gemäss Oberbegriff des Anspruchs 1 bzw. 2. Ein solches Bauelement ist z.B. aus der EP-A-0 121 068 bekannt.

In der Leistungselektronik, bei Umrichtern oder gesteuerten elektrischen Antrieben, gewinnen abschaltbare Leistungshalbleiter, beispielsweise in der Gestalt von über das Gate abschaltbaren Thyristoren (GTO = Gate Turn Off), zunehmend an Bedeutung.

Ein solcher GTO-Thyristor, wie er in der EP-A-0 022 355 beschreiben ist, weist zwischen seiner Anode und seiner Kathode eine Folge von vier Schichten unterschiedlicher Dotierung auf, die meist als p-Emitter, n-Basis, p-Basis und n-Emitter bezeichnet werden. Der p-Emitter steht mit dem Anodenkontakt in Verbindung, der n-Emitter mit dem Kathodenkontakt. Die p-Basis ihrerseits ist kathodenseitig in irgendeiner Weise an die Oberfläche geführt und mit einem geeigneten Gatekontakt versehen, über den das Bauelement gesteuert werden kann.

Um ein Abschalten über das Gate erreichen zu können, ist üblicherweise der Kathodenkontakt in Form schmaler, fingerförmiger Bereiche ausgeführt, die allseitig von dem dazwischenliegenden Gatekontakt umgeben werden. Kathodenkontakt und Gatekontakt liegen dabei entweder in einer Ebene, oder aber in unterschiedlichen Ebenen, dergestalt, dass die Ebene des Gatekontaktes gegenüber der Ebene des Kathodenkontaktes abgesenkt ist.

Die Abschaltgeschwindigkeit eines solchen bekannten GTO-Thyristors hängt u.a. davon ab, wie schnell die Ladungsträger, die im durchgeschalteten Zustand die Basis überschwemmen, zur Anodenseite hin abgesaugt werden können. Um den Absaugvorgang beim Abschalten zu beschleunigen, werden daher anodenseitig, über die Fläche verteilt, Kurzschlüsse zwischen der n-Basis und dem Anodenkontakt vorgesehen, welche die dazwischenliegende p-Emitter-Schicht überbrücken.

Die elektrischen Kenngrössen dieser Kurzschlüsse können jedoch nicht einseitig beliebig auf eine optimierte Abschaltgeschwindigkeit hin ausgewählt werden, da sich zugleich andere Eigenschaften des Bauelements bei dieser Optimierung deutlich verschlechtern, so dass nur ein begrenzter Spielraum für die Auslegung der Kurzschlüsse verbleibt.

Darüber hinaus liegt das Abschaltverhalten mit den einmal eingebauten Kurzschlüssen fest und kann nicht weiter beeinflusst werden.

Eine vergleichbare Situation existiert auch bei einem anderen Typ von abschaltbarem Leistungshalbleiter, dem feldgesteuerten Thyristor (FCTh = Field Controlled Thyristor), wie er z.B. aus der DE-A-29 32 043 bekannt ist. Beim FCT wird eine schwach n-dotierte Kanalschicht von von einer p-dotierten Anodenschicht und einer n-dotierten Kathodenschicht eingeschlossen. In die Kanalschicht hinein ragen p-dotierte Gatebereiche, die mit dem Gatekontakt in Verbindung stehen und mit dem Kanal einen P-N-Uebergang bilden, der bei geeigneter Vorspannung den Stromfluss durch den Kanal ein- und schliesslich abschnürt. Auch hier werden anodenseitig Kurzschlüsse zwischen dem Anodenkontakt und der Kanalschicht vorgesehen, um die Abschalteigenschaften zu verbessern.

Aus JP-A-59 217 365 ist ein GTO mit zwei planaren Gateanschlüssen bekannt. Das Ziel, das mit dem zusätzlichen Gate G2 verfolgt wird, besteht darin, den GTO mit einer Rückwärtsblockierfähigkeit auszustatten. Das Einschalten erfolgt allein über das herkömmliche Gate G1. Von besonderem Interesse ist das Anodengate G2 erst beim Abschalten und beim Rückwärtsblockieren. Damit man mit dem Gate G2 überhaupt eine Rückwärtsblockierfähigkeit erreichen kann, muss man das Gatesignal gleichzeitig mit demjenigen des ersten Gates G1 anlegen. Es muss nämlich vermieden werden, dass eine Rückwärtsspannung zwischen Anoden und Kathode auftritt, bevor die mit dem Gate G2 zwischen $n_B$ und $P_B$ erzeugte Raumladungszone aufgebaut ist. Es ist natürlich nicht zu vermeiden, dass durch dieses gleichzeitige Anlegen der Gatesignale auch ein gewisser Strom über das zweite Gate fliesst. Wie oben erläutert, wird aber der fragliche Strom aufgrund der speziellen Gatestruktur nicht sehr gross sein, zumindest nicht so gross, dass die Abschaltzeit wesentlich verkürzt werden kann.

Aus der US-A-4,086,611 geht ein SITh hervor, der vom Prinzip her mit zwei Gateanschlüssen arbeitet. Die Gemeinsamkeit zwischen SITh und FCTh liegt im grundlegenden Prinzip, den Strom über einen Feldeffekt zu steuern. Trotz dieser Gemeinsamkeit haben aber die entsprechenden Bauelemente völlig unterschiedliche Merkmale und Kennlinien. Während der SITh eine negative Kennlinie hat, zeichnet sich der FCTh durch eine Diodenkennlinie aus. Entsprechend ist auch die Gatestruktur im einzelnen verschieden ausgebildet. Der SITh kat ein vergrabenes Gate, d.h. die hochdotierte Gateschicht ist im wesentlichen vollständig im Grundmaterial vergraben. Sie ist hochdotiert und mit sog. Kurzkanälen für den Stromdurchfluss versehen. Im Gegensatz dazu ist das FCTh Gate als Langkanalstruktur ausgebildet. Das heisst die den Kanal bildenden Kathodenfinger sind in ihrer Höhe (Stromflussrichtung) mindestens vergleichbar mit ihrer Breite (laterale Richtung). Damit das vergrabene Gate kontaktiert werden kann, muss das Bauelement am Rand angeätzt werden. Der Teil der Schicht, der als Steuerung wirkt ist somit vollständig im Halbleiterkörper begraben. Die am Rand benötigte vertikale Struktur hat nichts mit der Funktionsweise des vergrabenen Gates als solches zu tun. Bei der FCTh Struktur ist die Ausbildung von Gatefingern dagegen in diesem Sinn von zentraler Bedeutung.

Bei einem weiteren bekannten abschaltbaren Bauelement, dem Thyristor der statischen Induktionsbauart (SITh = Static Induction Thyristor) ist das Problem der Verbesserung des Abschaltverhaltens auf ähnliche Weise gelöst worden (siehe z.B. Fig. 17 der DE-A-30 02 526).

Aufgabe der vorliegenden Erfindung ist es nun, ein abschaltbares Halbleiterbauelement zu schaffen, bei dem das Schaltverhalten, insbesondere das Abschaltverhalten, durch Steuerung von aussen beeinflusst werden kann und das eine Verwendung in einer neuartigen Kaskodenschaltung erlaubt.

Die Aufgabe wird bei einem Halbleiterbauelement der eingangs genannten Art durch die Merkmale aus dem Kennzeichen des Anspruchs 1 bzw. 2 gelöst.

Der Kern der Erfindung besteht darin, neben der bei einem über ein Gate abschaltbaren Halbleiterbauelement in bekannter Weise vorhandenen, kathodenseitigen ersten Gatestruktur eine vergleichbare zweite, anodenseitige Gatestruktur vorzusehen, die bei geeigneter Ansteuerung das Absaugen der Ladungsträger beim Abschalten beschleunigt, die Gesamtverlustleistung verringert und insbesondere die Möglichkeit einer Doppelkaskodenschaltung in Kombination mit zwei Feldeffekttransistoren bietet.

Obgleich im Rahmen der Erfindung die zweite Gatestruktur mit dem zweiten Gatekontakt bei jedem bekannten, über ein Gate abschaltbaren Halbleiterbauelement vorgesehen werden kann, liegt einer bevorzugten Ausführungsform der Erfindung eine fein unterteilte stufenförmige Gatestruktur zugrunde, wie sie aus der EP-A-0 121 068 bekannt ist und wahlweise in Form eines GTO oder eines FCTh verwirklicht werden kann.

Weitere Ausführungsbeispiele ergeben sich aus den Unteransprüchen.

Die Erfindung soll nun nachfolgend im Zusammenhang mit der Zeichnung anhand von Ausführungsbeispielen näher erläutert werden. Es zeigen:

Fig. 1A    im Querschnitt ausschnittsweise den Aufbau eines GTO nach dem Stand der Technik mit einer ersten, kathodenseitigen Gatestruktur;

Fig. 1B    einen der Fig. 1A entsprechenden Querschnitt durch einen FCTh nach dem Stand der Technik;

Fig. 2A    ein erstes Ausführungsbeispiel der Erfindung mit einem GTO gemäss Fig. 1A, der nunmehr eine zweite, anodenseitige Gatestruktur in einer ersten Konfiguration aufweist;

Fig. 2B    ein zweites Ausführungsbeispiel der Erfindung mit einem GTO gemäss Fig. 1A, der nunmehr eine zweite, anodenseitige Gatestruktur in einer zweiten, feldgesteuerten Konfiguration aufweist,

Fig. 3A    ein drittes Ausführungsbeispiel, das nicht Teil der Erfindung ist, mit einem FCTh gemäss Fig. 1B, der nunmehr eine zweite, anodenseitige Gatestruktur in der ersten Konfiguration gemäss Fig. 2A aufweist;

Fig. 3B    ein viertes Ausführungsbeispiel, das nicht Teil der Erfindung ist, mit einem FCTh gemäss Fig. 1B, der nunmehr eine zweite, anodenseitige Gatestruktur in der zweiten Konfiguration gemäss Fig. 2B aufweist;

Fig. 4    die Profile der Dotierungskonzentration sowie der Elektronen- und Löcherkonzentration in einem bekannten GTO gemäss Fig. 1A, wie sie als Grundlage für eine vergleichende Simulationsrechnung verwendet worden sind;

Fig. 5    die Fig. 4 entsprechenden Profile in einer Struktur gemäss Fig. 2A für die vergleichende Simulationsrechnung;

Fig. 6    das zeitliche Abschaltverhalten des bekannten GTO mit den Profilen gemäss Fig. 4 als Ergebnis der Simulationsrechnung;

Fig. 7    das Fig. 6 entsprechende Abschaltverhalten des erfindungsgemässen Bauelements mit den Profilen gemäss Fig. 5;

Fig. 8    den zeitlichen Verlauf der Anodenströme im Abschaltfall aus Fig. 6 und 7 im logarithmischen Massstab im Vergleich;

Fig. 9    im Vergleich die Gesamtverlustleistungen und -energien für beide Bauelemente im simulierten Abschaltverlauf;

Fig. 10    im Vergleich die Verlustleistungen und -energien in den kathodenseitigen Gatekreisen beider Bauelemente im simulierten Abschaltverlauf;

Fig. 11    im Vergleich die Verlustleistungen und -energien in den beiden Gatekreisen (anodenseitig und kathodenseitig) des Bauelements nach der Erfindung im simulierten Abschaltverlauf;

Fig. 12A    eine einfache Kaskodeschaltung eines bekannten abschaltbaren Bauelements mit einem Feldeffekttrasistor (FET);

Fig. 12B    eine Verwendung des neuen Bauelements in einer doppelten Kaskodeschaltung mit zwei FETs.

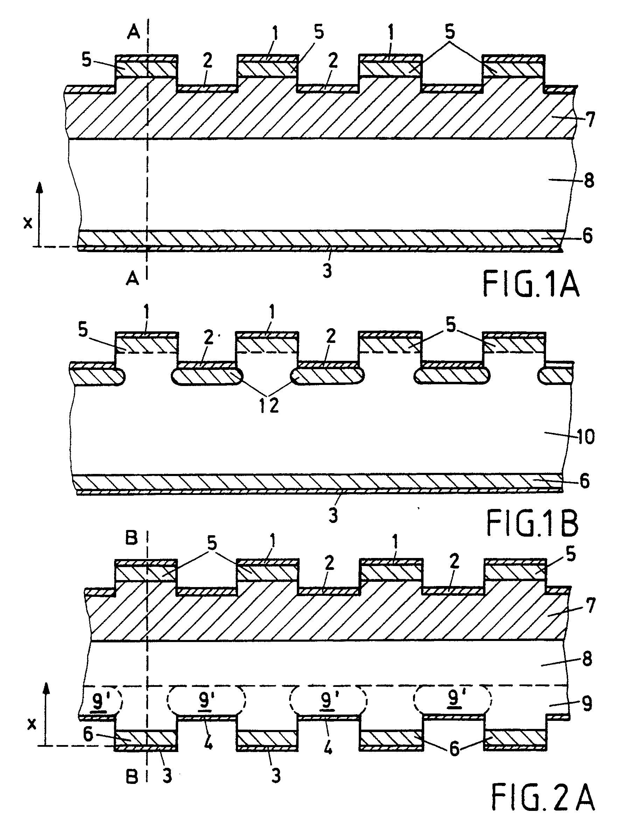

Der Querschnitt durch die Schichtstruktur eines, z.B.-aus der EP-A-0121 068 bekannten, über ein Gate abschaltbaren Bauelements (hier in der Gestalt eines GTO) ist in der Fig. 1A ausschnittsweise dargestellt. Zwischen der unten liegenden Anode und der oben liegenen Kathode ist eine Mehrzahl von unterschiedlich dotierten Schichten angeordnet. Im einzelnen sind dies eine p-dotierte Anodenschicht 6, beim GTO meist als p-Emitter bezeichnet, eine n-dotierte n-Basisschicht 8, eine p-dotierte p-Basisschicht 7 sowie eine n-dotierte Kathodenschicht 5 (n-Emitter), die im vorliegenden Fall durch tiefe Gräben in schmale, streifenförmige Bereiche unterteilt ist.

Die Gräben reichen von der kathodenseitigen Oberfläche bis in das Gebiet der p-Basisschicht 7. Auf den Böden der Gräben ist ein erster Gatekontakt 2 vorgesehen, der zwischen den durch die Gräben getrennten Kathodenfingern einzelne, getrennte Bereiche bildet, ausserhalb der Kathodenfinger jedoch eine zusammenhängende, metallische Kontaktfläche darstellt.

Für den Anoden- und Kathodenanschluss sind ein entsprechender Anodenkontakt 3 auf der Unterseite der Anodenschicht 6 und Kathodenkontakte 1 auf den Oberseiten der Kathodenschicht 5 bzw. der Kathodenfinger vorgesehen.

Angaben über die geometrischen Abmessungen der einzelnen Schichten und der stufenförmigen Gatestruktur sowie Angaben über geeignete Dotierungskonzentrationen können der bereits genannten EP-A-0 121 068 entnommen werden, so dass an dieser Stelle ein näheres Eingehen darauf nicht erforderlich ist.

Eine weitere aus dieser Druckschrift bekannte Struktur eines über ein Gate abschaltbaren Halbleiterbauelements (nunmehr in der Gestalt eines FCTh) ist in der Fig. 1B ausschnittsweise wiedergegeben. Anstelle der Vierschichtfolge aus Fig. 1A ist hier zwischen Anode und Kathode im Prinzip eine Dreischichtfolge angeordnet, welche die bereits erwähnte Anodenschicht 6 (p-dotiert), die Kathodenschicht 5 (n-dotiert) und ersten Gatekontakt 2, Anodenkontakt 3 und Kathodenkontakte 1 als Anschlusskontakte enthält. Anstelle der beiden Basisschichten 7 und 8 aus Fig. 1A tritt nun eine schwach n-dotierte n-Kanalschicht 10, in die unter den Böden der Gräben p-dotierte p-Gatebereiche 12 eindiffundiert sind, die mit dem ersten Gatekontakt 2 in Verbindung stehen und zusammen mit der n-Kanalschicht 10 P-N-Uebergänge bilden, die bei geeigneter Gatevorspannung den Stromfluss durch die n-Kanalschicht 10 zwischen den Gräben hindurch einschnüren und unterbinden.

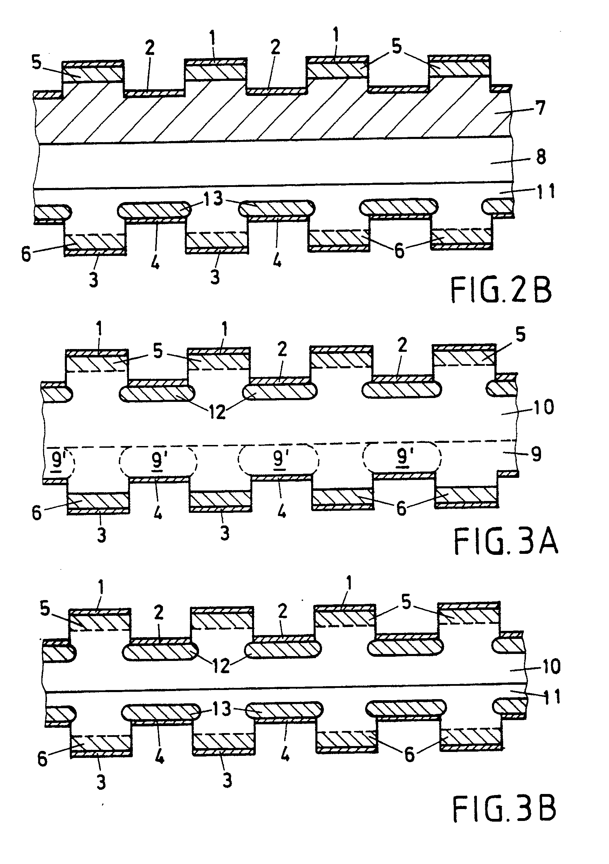

Diese beiden, in den Fig. 1A und 1B dargestellten, aus der EP-A1 0 121 068 bekannten Bauelementekonfigurationen bilden den Ausgangspunkt für insgesamt zwei Ausführungsbeispiele des erfindungsgemässen Halbleiterbauelements mit einer zweiten anodenseitigen Gatestruktur. Die zwei Ausführungsbeispiele (Fig. 2A und 2B) nehmen Bezug auf die Konfiguration aus Fig. 1A. Zwei weiteren Beispiele (Fig. 3A und 3B) gehen aus von einer Konfiguration gemäss Fig. 1B.

In der in Fig. 2A wiedergegebenen Struktur sind gegenüber dem Ausgangspunkt in Fig. 1A anodenseitig zwei wesentliche Veränderungen vorgenommen worden: Zum einen ist jetzt auch die Anodenschicht 6, analog zur Kathodenschicht 5, durch bis in die nächste Schicht reichende Gräben in einzelne schmale, streifenförmige Bereiche unterteilt und die Böden dieser Gräben ebenfalls mit einem Kontakt, dem zweiten Gatekontakt 4 versehen. Zum anderen ist in der n-Basisschicht 8, durch die gestrichelte Linie in Fig. 2A angedeutet, angrenzend an die Anodenschicht 6, eine Kontaktierungsschicht 9 angeordnet, die gegenüber der n-Basisschicht 8 stärker n-dotiert ist und einen guten elektrischen Kontakt zwischen dem zweiten Gatekontakt 4 und der n-Basisschicht 8 vermitteln soll. Zugleich kann diese zusätzliche Schicht 9 auch die Funktion einer an sich bekannten, sogenannten Stoppschicht übernehmen. Diese Kontaktierungsschicht braucht jedoch nicht unbedingt durchgehend ausgebildet sein, sondern kann auch nur, wie in den Fig. 2A und 3A durch die gestrichelt eingezeichneten Bereiche 9' angedeutet, lokal unter dem zweiten Gatekontakt 4 eindiffundiert werden. In diesem Falle entfällt die zusätzliche Funktion einer Stoppschicht.

Die anodenseitigen Gräben bilden nun eine zweite anodenseitige Gatestruktur, über die, analog wie bei der ersten Gatestruktur, das Bauelement von aussen gesteuert werden kann. Auf diese Weise kann über das nun vorhandene zweite Gate beim Abschalten des Bauelements das Absaugen der Ladungsträger aus der n-Basisschicht 8 wirkungsvoll unterstützt und der Abschaltvorgang deutlich beschleunigt werden.

Während in dem ersten Ausführungsbeispiel gemäss Fig. 2A beide Gatestrukturen die Ausgestaltung eines GTO-Gates haben, kann die anodenseitige zweite Gatestruktur, wie im zweiten Ausführungsbeispiel der Fig. 2B dargestellt, auch nach Art des aus Fig. 1B bekannten FCTh-Gates ausgeführt sein.

In diesem Falle ist zwischen der n-Basisschicht 8 und der Anodenschicht 6 eine p-dotierte Kanalschicht 11 angeordnet, in die unter den Böden der anodenseitigen Gräben eindiffundierte n-dotierte n-Gatebereiche 13 hineinreichen (Fig. 2B). Es resultiert dann eine zweite anodenseitige Gatestruktur, die der ersten kathodenseitigen Gatestruktur aus Fig. 1B in der geometrischen Auslegung vollkommen entspricht, während die Dotierungen in den einzelnen Schichten jeweils genau umgekehrt sind, d.h. an die Stelle einer p-Dotierung eine n-Dotierung tritt, und umgedreht. Ein Bauelement dieser Art weist dann ein erstes, stromgesteuertes Gate und ein zweites, feldgesteuertes Gate auf.

Das dritte Ausführungsbeispiel der Fig. 3A (das nicht Teil der Erfindung ist) geht von der bekannten FCTh-Konfiguration der Fig. 1B aus und führt die zweite, anodenseitige Gatestruktur dadurch ein, dass in der n-Kanalschicht 10, angrenzend an die Anodenschicht 6, eine gegenüber der n-Kanalschicht 10 stärker n-dotierte Kontaktierungsschicht 9 bzw. 9' eingebaut wird, wie sie bereits im Ausführungsbeispiel der Fig. 2A beschrieben worden ist. Gleichzeitig sind auch wieder entsprechende anodenseitige Gräben vorgesehen, welche die Anodenschicht 6 in schmale, streifenförmige Bereiche unterteilen, bis in die Kontaktierungsschicht hineinreichen und auf ihren Böden wieder mit dem zweiten Gatekontakt 4 versehen sind.

Im dritten Ausführungsbeispiel ist also ein kathodenseitiges, feldgesteuertes, erstes FCTh-Gate mit einem anodenseitigen, stromgesteuerten, zweiten GTO-Gate kombiniert.

Im vierten Ausführungsbeispiel der Fig. 3B (das nicht Teil der Erfindung ist) schliesslich sind beide Gatestrukturen als feldgesteuerte FCTh-Gates ausgeführt. Zwischen der Anodenschicht 6 und der Kathodenschicht 5 liegen hier die aus der Fig. 2B bereits bekannte p-Kanalschicht 11 und die aus Fig. 3A bekannte n-Kanalschicht 10.

Die für die Feldsteuerung benötigten P-N-Uebergänge werden durch die beiden Kanalschichten 10 und 11 und entsprechend umgekehrt dotierte Gatebereiche 12 und 13 gebildet.

Die Auswirkungen der zweiten anodenseitigen Gatestruktur auf das Schaltverhalten des Halbleiterbauelements sind mittels einer sehr realitätsnahen Rechnersimulation untersucht worden. Für die Rechnersimulation wurde ein speziell entwickeltes Rechnerprogramm COMPASS (Computer Programm für the Analysis of Semiconductors) verwendet, welches in der Dissertation von C. Abbas "Transient One-Dimensional Numerical Analysis of Bipolar Power Semiconductor Devices", ETH Zürich, No. 7614, 1984, beschrieben und erläutert ist.

Wie aus dieser Dissertation zu entnehmen ist, führt die Simulation mit dem Programm COMPASS zu realistischen Ergebnissen, die mit gemessenen Werten in sehr guter Uebereinstimmung stehen. Aus diesem Grunde können die Vorteile des erfindungsgemässen gegenüber dem herkömmlichen Halbleiterbauelement direkt an den mit diesem Programm gewonnenen Simulationsergebnissen deutlich gemacht werden.

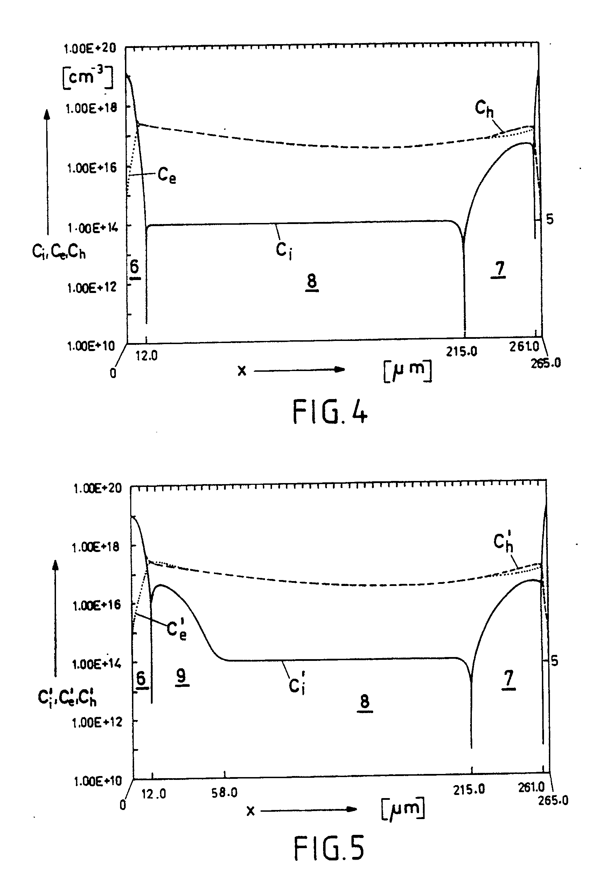

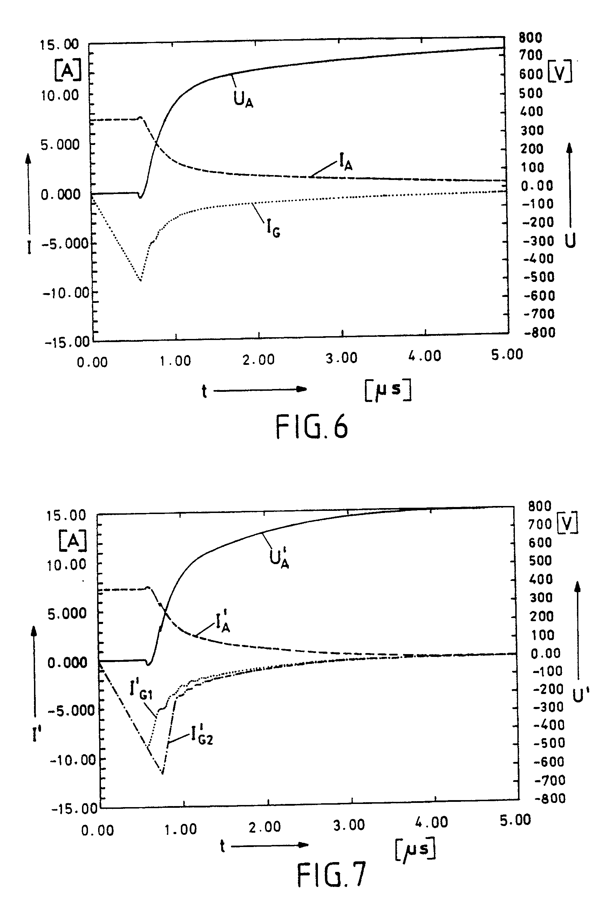

Die vergleichende Simulation geht aus von einem Dotierungsprofil der Dotierungskonzentration $c_i$ gemäss Fig. 4 für das herkömmliche Bauelement nach Fig. 1A und einem Dotierungsprofil der Dotierungskonzentration $c_i'$ gemäss Fig. 5 für ein neues Bauelement gemäss dem Ausführungsbeispiel der Fig. 2A mit doppeltem GTO-Gate (in der folgenden Diskussion der Simulationsergebniss werden die Grössen für das herkömmliche Bauelement ungestrichen, für das neuartige Bauelement zur Unterscheidung dagegen stets gestrichen verwendet).

Die Dotierungsprofile aus den Fig. 4 und 5 beziehen sich auf die Schnittlinien A-A in Fig. 1A bzw. B-B in Fig. 2A. Als Ortsparameter x ist die Entfernung von der unteren Begrenzungsfläche der Anodenschicht 6 gewählt, wie dies in beiden Figuren durch den eingezeichneten Pfeil angedeutet ist.

Wie aus den Figuren 4 und 5 hervorgeht, hat die Anordnung der verschiedenen Schichten 6, 8, 7, 5 bzw. 6, 9, 8, 7, 5 ohne die Kontakte eine gesamte Dicke von jeweils 265 $\mu$m, wobei 12 $\mu$m auf die Anodenschicht 6, 46 $\mu$m auf die Kontaktierungsschicht 9, 203 $\mu$m bzw. 157 $\mu$m auf die n-Basisschicht 8, 46 $\mu$m auf die p-Basisschicht 7, und 4 $\mu$m auf die Kathodenschicht 5 entfallen.

Neben den Profilen der Dotierungskonzentration $c_i$ bzw. $c_i'$ sind in den Figuren 4 und 5 zur Vedeutlichung der Ladungsträgerverhältnisse zusätzlich die sich einstellenden Elektronenkonzentrationen $c_e$ bzw. $c_e'$ und Löcherkonzentrationen $c_h$ bzw. $c_h'$ eingetragen.

Der wesentliche Unterschied zwischen den beiden dargestellten Dotierungsprofilen besteht darin, dass anodenseitig die zusätzliche, höher n-dotierte Kontaktierungsschicht 9 sich im Profil durch einen Buckel im Abstand zwischen x = 12 $\mu$m und x = 58 $\mu$m (Fig. 5) bemerkbar macht.

Als Ergebnis der Simulation des Abschaltverhaltens sind in Fig. 6 für das herkömmliche Bauelement (Fig. 1A und 4) die zeitlichen Verläufe der Anodenspannung $U_A$ des Anodenstroms $I_A$ und des Gatestroms $I_G$ aufgetragen, wobei eine von aussen angelegte Spannung von 800 V, ein Lastwiderstand von 109 Ohm und eine Gatespannung von -12 V vorgegeben worden sind.

Man erkennt deutlich den zeitlichen Ablauf des Abschaltvorgangs, bei dem zunächst über das Gate Strom gezogen wird, der nach dem Ausräumen der Ladungsträger zusammen mit dem Anodenstrom $I_A$ abklingt, während das Bauelement zunehmend sperrt und entsprechend Spannung aufnimmt.

Die mit Fig. 6 vergleichbaren Simulationsergebnisse für eine neuartige Doppelgatestruktur (Fig. 2A und 5) sind in Fig. 7 wiedergegeben, wobei die gestrichenen Grössen $I'_{G1}$, $I'_A$ und $U'_A$ den Grössen $I_G$, $I_A$ und $U_A$ entsprechen, während der Gatestrom $I'_{G2}$ für das anodenseitige zweite Gate als neue Grösse hinzukommt. Die äusseren Parameter sind im übrigen dieselben wie bei Fig. 6.

Durch direkten Vergleich der Figuren 6 und 7, insbesondere im Zeitbereich oberhalb von t = 2 $\mu$s wird bereits deutlich, dass die Ströme $I'_A$, $I'_{G1}$ und $I'_{G2}$ schneller abfallen, als die Ströme $I_A$ und $I_G$. Analog nimmt das neuartige Bauelement auch schneller die Anodenspannung $U'_A$ auf als das herkömmliche Bauelement seine Anodenspannung $U_A$.

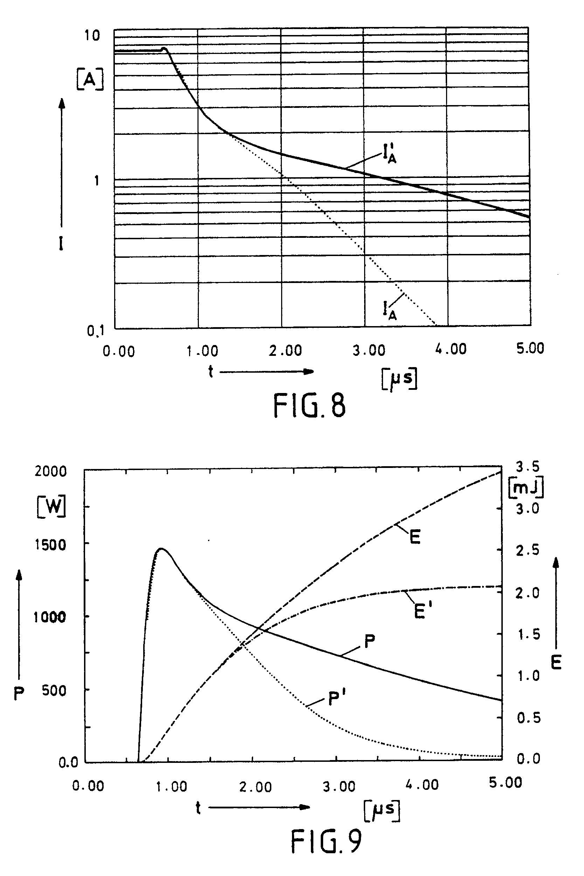

Besonders deutlich wird dieser Unterschied im Abschaltverhalten in der vergleichenden logarithmischen Auftragung der beiden Anodenströme $I_A$ und $I'_A$ über der Zeit in Fig. 8.

Aus dieser Fig. 8 geht hervor, dass die Speicherzeit beider GTO-Thyristoren identisch ist (weil die Konfiguration auf der Kathodenseite gleichgeblieben ist), die Fallzeit des neuartigen Doppelgate-Bauelements jedoch viel kleiner ist als die des herkömmlichen Bauelements, nämlich nur etwa 1,6 $\mu$s anstelle von sonst 3,4 $\mu$s. Hier wird also die deutliche Verbesserung im Abschaltverhalten durch das zweite anodenseitige Gate erkennbar.

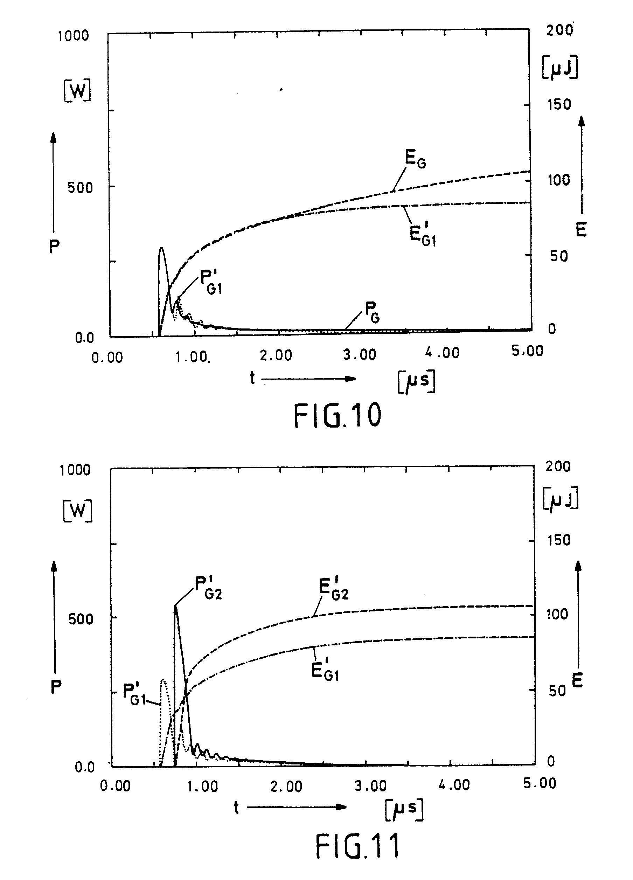

Weitere Vorteile sind aus einem direkten Vergleich der Verlustleistungen und Verlustenergien (Fig. 9 und 10) ersichtlich. Während das Maximum beider Verlustleistungen P und P' gleich ist (hier etwa 1500 W), fällt die Verlustleistung P' des neuartigen Bauelements schneller ab, als die Verlustleistung P des herkömmlichen GTO. Entsprechend günstiger ist auch das Verhältnis zwischen den Gesamtverlustleistungen E' und E beider Bauelemente.

Die Fig. 10 vergleicht die bei der Simulation erhaltenen Gateverlustleistungen $P_G$ und $P'_{G1}$, sowie die Gate-Gesamtverlustenergien $E_G$ und $E'_{G1}$ in den kathodenseitigen Gatekreisen beider Bauelemente. Auch hier schneidet das neuartige Bauelement ($E'_{G1}$ !) deutlich besser ab. Es ist jedoch andererseits zu berücksichtigen, dass bei dem neuartigen Bauelement im zweiten, anodenseitigen Gatekreis eine zusätzliche Verlustenergie auftritt ($E'_{G2}$ in Fig. 11; Verlustleistung: $P'_{G2}$ ), so dass die Gesamtverlustenergie bei zwei Gatekreisen 0,19 mJ gegenüber 0,11 mJ bei nur einem Gatekreis beträgt.

Zusammenfassend kann die Wirkung des zweiten, anodenseitigen Gates wie folgt beschrieben werden: Erstens wird während dem Abschaltprozess durch die Steuerung über das zweite Gate eine weitere Injektion von Ladungsträgern aus der Anode unterdrückt. Zweitens werden die in der Basisschicht gespeicherten Ladungsträger auch anodenseitig abgeführt. Bei den Ausführungsbeispielen der Fig. 2A und 3A, bei denen das zweite Gate ein GTO-Gate ist, geschieht dies sogar, ohne dass sich ein P-N-Uebergang zwischen dem zweiten Gatekontakt 4 und den in der n-Basisschicht 8 gespeicherten Ladungsträgern befindet.

Gegenüber den im dem Stand der Technik eingesetzten Anodenkurzschlüssen weist das erfindungsgemässe Bauelement den Vorzug auf, dass mit dem zusätzlichen anodenseitigen Gatekreis schaltungstechnisch auf das Schaltverhalten eingewirkt werden kann, und dass, wie nachfolgend beschrieben, das Bauelement in einer neuartigen Doppelkaskodeschaltung Verwendung finden kann.

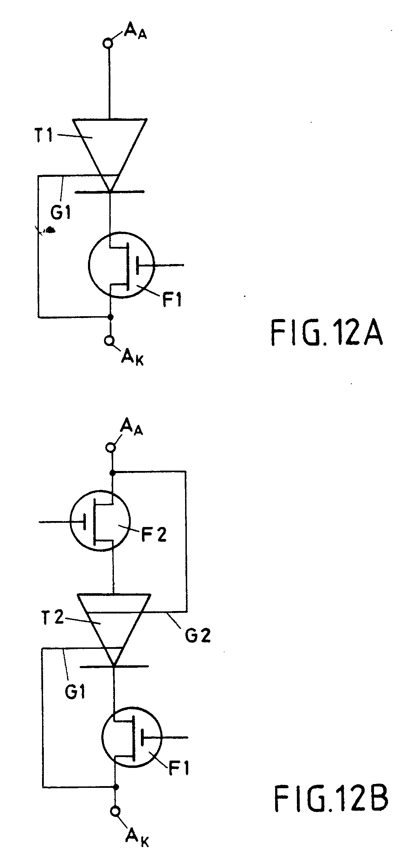

Eine einfache Kaskodeschaltung mit einem herkömmlichen über ein Gate abschaltbaren Halbleiterbauelement und einem Leistungs-MOSFET ist in Fig. 12A dargestellt. Diese Bauelementekombination umfasst die Serienschaltung eines Thyristors T1 und eines Feldeffekttransistors F1 zwischen einem anodenseitigen Aussenanschluss $A_A$ und einem kathodenseitigen Aussenanschluss $A_K$, wobei der Feldeffekttransistor F1 auf der Kathodenseite des Thyristors T1 angeordnet ist. Das Gate G1 des Thyristors T1 ist zum kathodenseitigen Aussenanschluss $A_K$ geführt.

In dieser Kaskodeschaltung muss der Feldeffekttransistor F1 im durchgeschalteten Zustand der Bauelementekombination den gesamten Laststrom führen können. Im abgeschalteten Zustand übernimmt dagegen der bipolare Thyristor T1 die gesamte Sperrspannung.

Nimmt man zum Ausschalten der Kaskode die Steuerspannung vom Gate des MOSFET weg, sperrt dieser innerhalb von einigen 100 nsec und der Strom wird zwangsweise von der Kathode des Thyristors T1 auf seinen Gatekreis (G1) kommutiert. Der Thyristor T1 schaltet dann abrupt ab und nimmt die gesamte Sperrspannung auf.

Mit dem neuartigen Halbleiterbauelement mit zweifach-Gate lässt sich nun eine Doppelkaskodeschaltung gemäss Fig. 12B aufbauen. Der Thyristor T2 ist hier kathodenseitig mit einem ersten FET F1 und anodenseitig mit einem zweiten FET F2 zwischen den kathodenseitigen und anodenseitigen Aussenanschlüssen $A_K$ und $A_A$ in Serie geschaltet. Das erste Gate G1 ist dabei mit $A_K$, das zweite Gate G2 mit $A_A$ verbunden.

Werden in dieser Doppelkaskodenschaltung nun beide MOSFETs F1 und F2 über ihre Gateanschlüsse abgeschaltet, kommutiert der Laststrom kathodenseitig auf den Gatekreis des ersten Gates G1 und anodenseitig auf den Gatekreis mit dem zweiten Gate G2. Dies hat zur Folge, dass die mit dem zweiten Gate erreichte beschleunigte Abschaltung auch in dieser Schaltungsanordnung voll zum Tragen kommt.

Insgesamt steht mit dem neuartigen Halbleiterbauelement ein abschaltbares Bauelement zur Verfügung, das folgende Vorteile aufweist:

- schnelleres Abschalten
- geringere Gesamtverlustleistung
- mögliche Verwendung in einer Doppelkaskodeschaltung
- schnelleres Einschalten
- zweite Gatestruktur kann mit denselben Prozessen erzeugt werden, wie die erste.

Es versteht sich, dass die Anordnung einer zweiten anodenseitigen Gatestruktur nicht auf die Schichtstrukturen der vier erläuterten Ausführungsbeispiele beschränkt ist, sondern in einfacher Weise bei jedem über ein Gate abschaltbaren Halbleiterbauelement im Rahmen der Erfindung realisiert werden kann.

**Patentansprüche**

1. Abschaltbares Halbleiterbauelement, welches
   a) eine Vierschichtfolge, bestehend aus p-dotierter Anodenschicht (6), n-Basisschicht (8, 9), p-Basisschicht (7) und n-dotierter Kathodenschicht (5), und
   b) auf der Kathodenseite eine zum Steuern und zum Abschalten des Bauelements geeignete erste, stromgesteuerte Gatestruktur mit einem ersten Gatekontakt (2), der mit der p-Basisschicht (7) in Verbindung steht, aufweist, wobei
   c) die p-Basisschicht (7) maximal 40 $\mu$m dick ist und die Kathodenschicht (5) maximal 8 $\mu$m dick ist und durch tiefe Gräben, auf deren Böden der erste Gatekontakt (2) angeordnet ist und deren Tiefe zwischen 10 $\mu$m und 20 $\mu$m beträgt, in schmale Bereiche einer Breite zwischen 20 $\mu$m und 300 $\mu$m derart unterteilt ist, dass das Verhältnis zwischen der Fläche der Kathodenschicht (5) und der derjenigen des ersten Gatekontakts (2) zwischen 1 und 4 liegt,
   dadurch gekennzeichnet, dass
   d) auf der Anodenseite eine zweite stromgesteuerte Gatestruktur mit einem zweiten Gatekontakt (4) vorgesehen ist, welche zweite Struktur dieselbe Geometrie wie die erste Gatestruktur aufweist, dass in der n-Basisschicht (8, 9), angrenzend an die Anodenschicht (6), eine gegenüber der n-Basisschicht stärker n-dotierte Kontaktierungsschicht (9, 9') vorhanden ist und dass die Anodenschicht (6) durch bis in die Kontaktierungsschicht (9, 9') reichende Gräben, auf deren Böden der zweite Gatekontakt (4) angeordnet ist, in schmale Bereiche unterteilt ist.

2. Abschaltbares Halbleiterbauelement, welches
   a) eine Vierschichtfolge, bestehend aus p-dotierter Anodenschicht (6), n-Basisschicht (8), p-Basisschicht (7) und n-dotierter Kathodenschicht (5), und
   b) auf der Kathodenseite eine zum Steuern und zum Abschalten des Bauelements geeignete erste, stromgesteuerte Gatestruktur mit einem ersten Gatekontakt (2), der mit der p-Basisschicht (7) in Verbindung steht, aufweist, wobei
   c) die p-Basisschicht (7) maximal 40 $\mu$m dick ist und die Kathodenschicht (5) maximal 8 $\mu$m dick ist und durch tiefe Gräben, auf deren Böden der erste Gatekontakt (2) angeordnet ist und deren Tiefe zwischen 10 $\mu$m und 20 $\mu$m beträgt, in schmale Bereiche einer Breite zwischen 20 $\mu$m und 300 $\mu$m derart unterteilt ist, dass das Verhältnis zwischen der Fläche der Kathodenschicht (5) und der derjenigen des ersten Gatekontakts (2) zwischen 1 und 4 liegt,
   dadurch gekennzeichnet, dass
   d) zwischen n-Basisschicht (8) und Anodenschicht (6) eine schwach p-dotierte p-Kanalschicht (11) vorgesehen ist,
   e) auf der Anodenseite eine zweite feldgesteuerte Gatestruktur mit einem zweiten Gatekontakt (4) vorgesehen ist, welche zweite Struktur dieselbe Geometrie wie die erste Gatestruktur aufweist, wobei
   f) die Anodenschicht (6) durch tiefe, bis in die p-Kanalschicht (11) reichende Gräben, auf deren Böden der zweite Gatekontakt (4) angeordnet ist, in schmale Bereiche unterteilt ist, und
   g) die auf den Böden der Gräben angeordneten zweiten Gatekontakte (4) von der p-Kanalschicht (11) durch darunterliegende, n-dotierte n-Gatebereiche (13) getrennt sind.

**Claims**

1. Turn-off semiconductor component which has
   a) a four-layer sequence consisting of p-doped anode layer (6), n base layer (8, 9), p base layer (7) and n-doped cathode layer (5), and
   b) on the cathode side, a first current-controlled gate structure, suitable for controlling and for turning off the component, comprising a first gate contact (2) which is connected to the p base layer (7), in which arrangement
   c) the p base layer (7) is 40 $\mu$m thick at most and the cathode layer (5) is 8 $\mu$m thick at most and is subdivided by deep trenches on the bottoms of which the first gate contact (2) is arranged and the depth of which is between 10 $\mu$m and 20 $\mu$m, into narrow regions of a width of between 20 $\mu$m

and 300 μm, in such a manner that the ratio between the area of the cathode layer (5) and that of the first gate contact (2) is between 1 and 4, characterised in that

d) a second current-controlled gate structure having a second gate contact (4) is provided on the anode side, which second structure has the same geometry as the first gate structure, in that, in the n base layer (8, 9), adjoining the anode layer (6), an n-doped contacting layer (9, 9') exists which is more strongly n-doped compared with the n base layer, and in that the anode layer (6) is subdivided into narrow regions by trenches which reach down into the contacting layer (9, 9') and on the bottoms of which the second gate contact (4) is arranged.

2. Turn-off semiconductor component, which has
a) a four-layer sequence consisting of p-doped anode layer (6), n base layer (8), p base layer (7) and n-doped cathode layer (5), and
b) on the cathode side, a first current-controlled gate structure, suitable for controlling and for turning off the component, comprising a first gate contact (2) which is connected to the p base layer (7), in which arrangement
c) the p base layer (7) is 40 μm thick at most and the cathode layer (5) is 8 μm thick at most and is subdivided by deep trenches on the bottom of which the first gate contact (2) is arranged and the depth of which is between 10 μm and 20 μm, into narrow regions of a width of between 20 μm and 300 μm, in such a manner that the ratio between the area of the cathode layer (5) and that of the first gate contact (2) is between 1 and 4, characterised in that
d) a weakly p-doped p-channel layer (11) is provided between n base layer (8) and anode layer (6),
e) a second field-controlled gate structure having a second gate contact (4) is provided on the anode side, which second structure has the same geometry as the first gate structure, in which arrangement
f) the anode layer (6) is subdivided into narrow regions by deep trenches which reach down into the p-channel layer (11) and on the bottoms of which the second gate contact (4) is arranged, and
g) the second gate contacts (4) arranged on the bottoms of the trenches are separated from the p-channel layer (11) by n-doped n-type gate areas (13) located thereunder.

**Revendications**

1. Composant semi-conducteur déclenchable, qui comporte :

a) une succession de quatre couches constituées d'une couche d'anode à dopage p (6), d'une couche de base n (8, 9), d'une couche de base p (7) et d'une couche de cathode à dopage n (5), et

b) sur le côté cathodique, une première structure de gâchette commandée par le courant convenant pour la commande et le déclenchement du composant, comportant un premier contact de gâchette (2) qui est en liaison avec la couche de base p (7), étant entendu que :

c) la couche de base p (7) a une épaisseur maximale de 40 μm et la couche de cathode (5), une épaisseur maximale de 8 μm et est subdivisée par des fosses profondes, sur le fond desquelles est disposé le premier contact de gâchette (2) et dont la profondeur est comprise entre 10 μm et 20 μm, en des domaines étroits d'une largeur comprise entre 20 μm et 300 μm, de telle sorte que le rapport entre la surface de la couche de cathode (5) et celle du premier contact de gâchette (2) est compris entre 1 et 4,

caractérisé en ce que :

d) sur le côté anodique, une seconde structure de gâchette commandée par le courant est prévue avec un second contact de gâchette (4), cette seconde structure présentant la même géométrie que la première structure de gâchette, que dans la couche de base n (8, 9) contiguë à la couche d'anode (6), une couche de mise en contact (9, 9') à dopage n plus fort que celui de la couche de base n est présente et que la couche d'anode (6) est subdivisée en des domaines étroits par des fosses allant jusque dans la couche de mise en contact (9, 9'), sur le fond desquelles est disposé le second contact de gâchette (4).

2. Composant semi-conducteur déclenchable qui comporte :

a) une succession de quatre couches constituées d'une couche d'anode (6) à dopage p, d'une couche de base n (8), d'une couche de base p (7) et d'une couche de cathode (5) à dopage n, et

b) du côté cathodique, une première structure de gâchette adéquate commandée par le courant pour la commande et le déclenchement du composant avec un premier contact de gâchette (2) qui est en liaison avec la couche de base p (7), étant entendu que :

c) la couche de base p (7) a une épaisseur maximale de 40 μm et la couche de cathode (5), une épaisseur maximale de 8 μm et est subdivisée par des fosses profondes sur le fond desquelles est disposé le premier contact de gâchette (2) et dont la profondeur est comprise entre 10 μm et 20 μm, en des domaines étroits d'une largeur comprise entre 20 μm et 300 μm, de telle sorte que le rapport entre la surface de la couche de cathode (5) et celle du premier contact de gâchette (2) est compris entre 1 et 4,

caractérisé en ce que :

d) entre la couche de base n (8) et la couche d'anode (5) est prévue une couche de canal p (11) à faible dopage p,

e) du côté anodique, une seconde structure de gâchette commandée par le champ est pourvue d'un second contact de gâchette (4), cette seconde structure présentant la même géométrie que la première structure de gâchette, de sorte que :

f) la couche d'anode (6) est subdivisée en des domaines étroits par de profondes fosses allant jusque dans la couche de canal p (11), sur le fond desquelles est disposé le second contact de gâchette (4), et

g) les seconds contacts de gâchette (4) disposés sur le fond des fosses sont séparés de la couche de canal p (11) par des domaines de gâchette n à dopage n (13) sous-jacents.

FIG.1A

FIG.1B

FIG.2A

FIG.2B

FIG.3A

FIG.3B

FIG. 4

FIG.5

FIG.6

FIG.7

FIG.8

FIG.9

FIG.10

FIG.11

FIG.12A

FIG.12B